# EUROPÄISCHE PATENTANMELDUNG

(11) **EP 1 343 201 A1**
(43) Veröffentlichungstag der Anmeldung: **10.09.2003**
(21) Anmeldenummer: 02005435.9
(22) Anmeldetag: 08.03.2002
(51) Int. Cl.: H01L 21/607, H01L 21/66

(54) **"Verfahren und Anordnung zur Herstellung und Qualitätsprüfung einer Drahtbondverbindung"**

(71) Anmelder: F & K Delvotec Bondtechnik GmbH, 85521 Ottobrunn (DE)
(72) Erfinder: Farassat, Farhad, Dr., 82024 Taufkirchen (DE)
(74) Vertreter: Popp, Eugen, Dr.

(57) **Zusammenfassung**

Verfahren zur Herstellung einer Drahtbondverbindung zwischen einem elektronischen Bauelement oder einer Baugruppe und einem Träger unter Energieeintrag in einen Bonddraht durch einen Ultraschallwandler, wobei während des Energieeintrages die Impedanz des Ultraschallwandlers in Abhängigkeit von der Zeit gemessen, die Kurvenform der Zeitanhängigkeit einer Auswertung anhand vorbestimmter Vergleichskriterien unterzogen und die in den Ultraschallwandler eingespeiste Energie und/oder eine auf den Bonddraht ausgeübte Bondkraft in Abhängigkeit von dem Auswertungsergebnis gesteuert wird.

## Beschreibung

Die Erfindung betrifft ein Verfahren zur Herstellung bzw. Qualitätskontrolle einer Drahtbondverbindung nach dem Oberbegriff des Anspruchs 1 bzw. 2 sowie eine Anordnung zur Durchführung dieser Verfahren. Sie betrifft weiter einen mit einer derartigen Anordnung ausgestatteten Drahtbonder.

Drahtbondverbindungen werden in elektronischen Geräten aller Art zur Kontaktierung von elektronischen Bauelementen und insbesondere integrierten Schaltkreisen (Chips) massenhaft eingesetzt. Die Qualität dieser Verbindungen bestimmt die Leistung und Zuverlässigkeit der entsprechenden elektronischen Geräte in erheblichem Maße. Daher wird von den Herstellern der elektronischen Geräte der Qualitätskontrolle großes Augenmerk geschenkt, und die Hersteller von Drahtbondmaschinen stehen der Forderung nach immer zuverlässigeren Prüf- und Prozesskontrollsystemen gegenüber.

Eines der am weitesten entwickelten und verbreiteten Bondverfahren ist das Ultraschall-Drahtbonden (_{"}Wedge Bonding"), dass im Grunde eine Mikro-Reibschweißtechnik darstellt. Hierbei wird - wie beispielsweise in der US 4 619 397 der Anmelderin beschrieben - ein Aluminiumdraht in Kontakt mit einer Substratfläche, mit der er stoffschlüssig zu verbinden ist, durch einen Ultraschallwandler einer schnellen Schwingung unterzogen und gleichzeitig auf die Oberfläche angedrückt. Unter der Einwirkung der Druckkraft (Bondkraft) und der Schwingungsenergie (Bondenergie) wird eine auf der Oberfläche befindliche Oxidschicht aufgebrochen und unter starker Verformung und lokaler Erwärmung eine stoffschlüssige Grenzschichtverbindung hergestellt.

Genauere Ausführungen zu diesem Verfahren sind hier verzichtbar, da es dem Fachmann seit langem bestens bekannt ist.

Zur Prüfung der auf dieser Weise hergestellten Bondverbindungen hat sich eine Vielzahl von Verfahren etabliert, von denen an dieser Stelle nur auf das Verfahren nach der US 4 984 730 der Anmelderin hingewiesen werden soll. In dieser Druckschrift wird ein Prüfverfahren beschrieben, welches auf der Erfassung einer Deformation des Bonddrahtes während des Bondprozesses und dem Vergleich mit einer Standard- bzw. Referenzkurve beruht. Zu weit von der Referenzkurve entfernt liegende aktuelle Deformationskurven werden als Indiz für ungenügende Qualität der Drahtbondverbindung gewertet, und die Erfassung solcher unzulässiger Abweichungen gibt Anlaß einer Verfahrensunterbrechung und Neueinstellung relevanter Prozessparameter.

Ein in gewissem Sinn ähnliches Verfahren zum Prüfen von durch Ultraschall-Drahtbonden hergestellten Verbindungen wird in der DE 44 47 073 C1 beschrieben. Hier stellt die Festigkeit der Verbindung die maßgebende Größe für die Bondgüte dar. Es wird vorgeschlagen, als relevanten Parameter die Geschwindigkeit bzw. den zeitlichen Verlauf der Deformation des Bonddrahtes und den zeitlichen Verlauf der Bondwerkzeugamplitude (Wedge Amplitude) während des Bondvorganges zu erfassen und durch einen Vergleich mit Referenzdaten zu bewerten. Dieses Verfahren ermöglicht die Festigkeitsprüfung jeder einzelnen Verbindung ohne wesentlichen zusätzlichen Zeitaufwand.

In der US 5 314 105 der Anmelderin wird ein System zur Steuerung eines Ultraschall-Drahtbondprozesses vorgeschlagen, bei dem der Bondprozess in Echtzeit bzw. Quasi-Echtzeit aufgrund einer Erfassung der Zeitabhängigkeit der Deformation des Bonddrahtes gesteuert wird. Speziell wird vorgeschlagen, die in den Ultraschallwandler eingespeiste Energie solange auf einem hohen Pegel zu belassen, bis sich in der Kurve der Zeitabhängigkeit ein starker Anstieg der Deformation zeigt, und sie dann auf einen vorbestimmten niedrigeren Wert abzusenken. Weiterhin wird-in einer bevorzugten Verfahrensführung - vorgeschlagen, den Ultraschallwandler gänzlich abzuschalten, wenn die Drahtdeformation im wesentlichen einen vorbestimmten Endwert erreicht hat.

In der GB 2 271 305 B der Anmelderin wird ein Steuerverfahren für einen Löt- bzw. Bondprozess vom Reflow-Typ vorgeschlagen, bei dem die zugeführte Energie für vorbestimmte Prozessabschnitte auf unterschiedliche Niveaus eingestellt wird. In dieser Druckschrift wird auch die Anwendung dieses Prinzips bei einem Drahtbonder der oben angesprochenen Art erwähnt.

Es hat sich gezeigt, dass die bisher vorgeschlagenen Verfahren und Anordnungen nicht in allen praktisch vorkommenden Materialund Prozesskonstellationen optimale Ergebnisse erbringen. Eine Steuerung oder gar Regelung des Bondprozesses in der Anfangsphase (den ersten fünf bis zehn ms) war nicht möglich, weil in diesem Zeitbereich keine auswertbare Deformation des Bonddrahtes auftritt.

Es ist daher Aufgabe der Erfindung, ein verbessertes Verfahren der gattungsgemäßen Art sowie eine zu dessen Durchführung geeigneter Anordnung bereitzustellen, die eine weitere Verbesserung der Qualitätssicherung von Drahtbondverbindungen ermöglichen.

Diese Aufgabe wird verfahrensseitig durch ein Verfahren mit den Merkmalen des Anspruches 1 bzw. 2 sowie vorrichtungsseitig durch eine Anordnung mit den Merkmalen des Anspruchs 10 gelöst.

Die Erfindung schließt den grundlegenden Gedanken ein, anhand einer geeigneten Größe eine Rückwirkung des Bondprozesses auf das Werkzeug - den Ultraschallwandler (Transducer) - und hierdurch eine wesentliche Zustandsänderung des Werkstücks - der Bonddraht-Substrat-Einheit mit der im entstehend begriffenen Bondverbindung - zu erfassen. Sie schließt weiter den Gedanken ein, als diese Größe die am Wandler gemessene Impedanz zu nutzen. Schließlich gehört zur Erfindung der Gedanke, die registrierte Zeitabhängigkeit der repräsentativen Größe (Impedanz) mit einer geeigneten Referenz zu vergleichen, die bei der Herstellung von qualitativ einwandfreien Bondverbindungen gewonnen wurde.

Die Erfindung ermöglicht eine verbesserte Steuerung bzw. Regelung des Bondprozesses, insbesondere in seiner Anfangsphase, in dem eine als Eingangsgröße des Steuerungs- bzw. Regelungsvorganges brauchbare Größe zugrunde gelegt wird, die in diesem Zeitbereich eine aussagekräftige Zeitabhängigkeit hat.

In einer ersten, relativ selbständigen Ausprägung des Erfindungsgedankens ist das vorgeschlagene Verfahren ein Herstellungsverfahren insofern, als es neben den oben erwähnten Aspekten den Gedanken einer Steuerung der in den Ultraschallwandler eingespeisten Energie (Bondenergie) oder der durch das Bondwerkzeug auf den Bonddraht ausgeübten Bondkraft (bond weight) oder beider Steuergrößen umfasst.

In einer zweiten Ausprägung des Erfindungsgedankens stellt das Verfahren insofern ein Prüfverfahren zur Qualitätskontrolle der erzeugten Bondverbindung dar, als sich aus der aufgenommenen Zeitabhängigkeit der Impedanz im Vergleich zur herangezogenen Differenz eine Entscheidung zur Güte der Bondverbindung herleiten lässt.

Der Erfinder hat anhand umfangreicher experimenteller Untersuchungen festgestellt, dass eine bestimmte charakteristische Kurvenform der Impedanz-Zeit-Kurve, die sich durch einen relativ steilen Anstieg bis zu einem ausgeprägten Maximum und einen anschließenden, zunächst steileren und dann flacher werdenden Abfall auszeichnet, als eindeutiges Indiz für eine qualitativ hochwertige Verbindung zu werten ist. Es versteht sich, dass für verschiedene Bondprozessparameter, insbesondere unterschiedliche Drahtzusammensetzungen und -abmessungen sowie verschiedenartige Substratoberflächen, die konkrete Zeitabhängigkeit der Impedanz und insbesondere die Lage des Maximums und die Werte der Anstiegs- und Abfallsgradienten unterschiedlich sind. Es lassen sich jedoch für jede Prozessparameterkonstellation mit einer begrenzten Zahl von Versuchen geeignete Referenzkurven ermitteln, die zum Vergleich mit einer aktuell erfassten Zeitabhängigkeit herangezogen werden können.

Die Auswertung der Kurvenform zur Steuerung- bzw. Regelung des Bondprozesses wird bevorzugt als Vergleich der während der Herstellung der Bondverbindung aufgenommenen Gesamt-Zeitabhängigkeit oder aber nur eines charakteristischen Abschnitts der Gesamtkurve mit einer Referenzkurve oder einer Schar von Referenzkurven ausgeführt. Eine signifikante Aussage zur Qualität der Bondverbindung liefert hierbei aus derzeitiger Sicht eine Auswertung mittels dreier vorbestimmter Impedanz-Zeit-Referenzflächen (nachfolgend bezeichnet als _{"}Referenzfenster"), durch die die registrierte Zeitabhängigkeit der Impedanz hindurchgehen muss, wenn eine qualitativ hochwertige Bondverbindung erzeugt wird.

Grundsätzlich kommt weiterhin auch eine numerische Auswertung charakteristischer Kurvenabschnitte, beispielsweise zur Gewinnung des Impedanz-Maximalwertes und eines Abfallsgradienten in einem sich an das Maximum anschließenden Kurvenbereich, und der numerische Vergleich mit entsprechenden Werten aus Referenzmessungen in Betracht. Es versteht sich, dass auch bei einer solchen Art der Auswertung für eine _{"}Gut"-Bewertung der aktuell erzeugten Bondverbindung bestimmte Toleranzwerte gegenüber den Referenzkurven definiert werden sollten.

In einer besonders bevorzugten Ausführung des vorgeschlagenen Herstellungs- bzw. Prüfverfahrens wird die vorgeschlagene Auswertung der Impedanz-Zeit-Kurve kombiniert mit einer Auswertung der Zeitabhängigkeit der Deformation des Bonddrahtes (wie sie als solche grundsätzlich aus der US 5 314 105 bekannt ist). Insbesondere wird der vorbekannte Gedanke einer stufenartigen Absenkung der Bondenergie zum Zeitpunkt eines deutlichen Anstiegs der Drahtdeformation kombiniert mit dem erfindungsgemäßen Gedanken der Steuerung der Bondenergie und/oder Bondkraft in Abhängigkeit vom charakteristischen Verlauf der Zeitabhängigkeit der Transducer-Impedanz. Analog lässt sich aus der kombinierten Auswertung beider Zeitabhängigkeiten - jeweils im Vergleich zu an guten Bondverbindungen gewonnenen Referenzkurven - eine besonders verlässliche Entscheidung zur Qualität der Bondverbindung treffen.

Wie auch die Qualitätsprüfung bzw. Verfahrenssteuerung allein aufgrund der Impedanz-Zeit-Abhängigkeit erfolgt hier die Qualitätsprüfung bzw. Verfahrenssteuerung aufgrund einer kombinierten Auswertung der Impedanz-Zeit-Kurve und Deformations-Zeit-Kurve in der Praxis bevorzugt automatisch, wobei zumindest Komponenten eines Regelungsablaufes bzw. -systems vorgesehen sind. Diese Regelungskomponente ist bei dem kombinierten Verfahren besonders ausgeprägt, da die am Transducer erfasste Impedanz und die in diesen eingespeiste Bondenergie in einem ursprünglichen physikalischen Zusammenhang stehen, der durch das Voranschreiten der Herstellung der Bondverbindung in gewissem Sinn _{"}moduliert" wird. Dieser Zusammenhang bietet eine physikalische Grundlage für die besagte Regelungskomponente.

Zu den oben erwähnten Verfahrensschritten und -aspekten korrespondieren Vorrichtungsaspekte einer zur Verfahrensdurchführung geeigneten Anordnung in für den Fachmann leicht erkennbarer Weise, so dass auf die Anordnungskomponenten nicht in allen Einzelheiten eingegangen werden muss. Es wird jedoch darauf hingewiesen, dass eine zur Qualitätsprüfung vorgesehene Anordnung nach obigem eine mit der Auswertungseinrichtung zum Vergleich der Impedanz-Zeit-Kurve mit geeigneten Referenzen verbundene Entscheidungseinrichtung zur Ausgabe einer Gut/Schlecht-Entscheidung hat. Bei einer zur Bondprozesssteuerung vorgesehenen Anordnung ist die Auswertungseinheit hingegen mit einer Bondenergie-Steuereinheit und/oder Bondkraft-Steuereinheit verbunden und steuert diese gemäß einem vorgegebenen (aus experimentellen Befunden abgeleiteten) Steueralgorithmus an.

Vorteile und Zweckmäßigkeiten der Erfindung ergeben sich im übrigen aus der nachfolgenden Beschreibung bevorzugter Ausführungsbeispiele der Erfindung anhand der Figuren. Von diesen zeigen:
- Fig. 1 bis 1C: graphische Darstellungen der Zeitabhängigkeit der Impedanz des Transducers und der Deformation des Bonddrahtes mit Referenzfenstern zur Auswertung der Impedanz-Zeit-Kurve
- Fig. 2: eine synaptische Darstellung der Zeitabhängigkeit von Impedanz und Deformation sowie einer geeignet gesteuerten Bondenergie, unter Kennzeichnung charakteristischer Zeitspannen,
- Fig. 3: eine schematische Darstellung einer ersten Anordnung zur Durchführung des erfindungsgemäßen Verfahrens in Art eines Funktions-Blockschaltbildes und
- Fig. 4: eine schematische Darstellung einer zweiten Anordnung zur Durchführung des erfindungsgemäßen Verfahrens in Art eines Funktions-Blockschaltbildes.

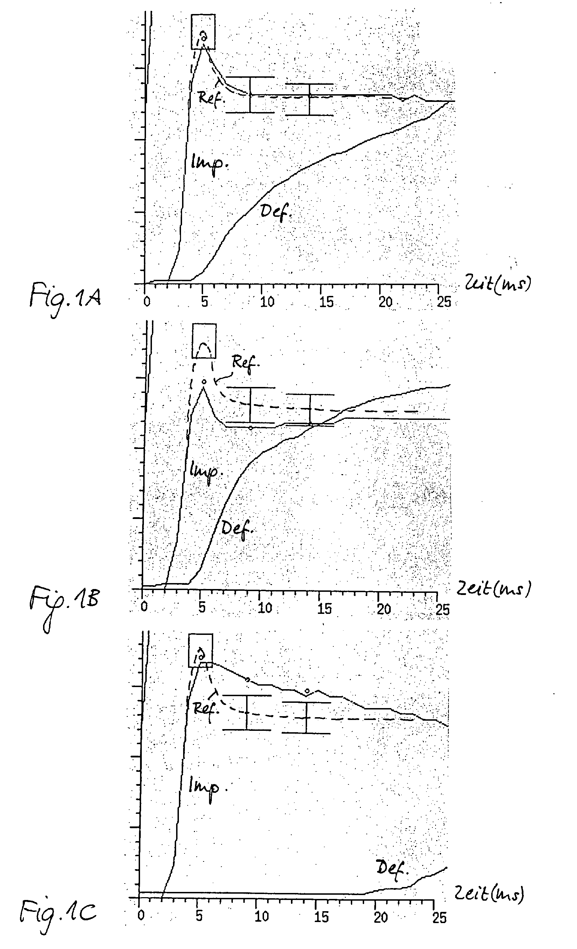

In Fig. 1A bis Fig. 1C sind drei Beispiele für an einem Drahtbonder aufgezeichnete Impedanz-Zeit-Kurven und Deformations-Zeit-Kurven dargestellt, wobei der Impedanz-Zeitabhängigkeit eine (gestrichelt gezeichnete) Referenzkurve sowie drei aus experimentellen Voruntersuchungen bestimmte Referenzfenster zugeordnet sind. Diese kennzeichnen einen zufriedenstellend verlaufenden Prozess, bei dem eine Drahtbondverbindung mit hoher Qualität entsteht.

Es ist zu erkennen, dass die Impedanz-Zeit-Kurve in Fig. 1A mit einem ausgeprägten Maximum bei ca. 5 ms und einem anschließenden steilen und dann flacher werdenden Abfall in einem engen Toleranzbereich nahe bei der Referenzkurve liegt und alle drei Zeitfenster durchläuft. Dagegen erreicht die Kurve aus Fig. 1B mit ihrem Maximum das erste Fenster nicht, bleibt im weiteren Kurvenverlauf auch unterhalb des zweiten Fensters und liegt insgesamt relativ weit unter der Referenzkurve. Die Kurve nach Fig. 1C durchläuft zwar das erste, nicht aber das zweite und dritte Referenzfenster und liegt praktisch in ihrem gesamten Verlauf jenseits des Zeitpunktes 6ms außerhalb der Toleranz über der Referenzkurve. Im Sinne des vorgeschlagenen Verfahrens ist die mit einer Zeitabhängigkeit nach Fig. 1A erzeugte Bondverbindung als gut zu bewerten, während Bondverbindungen, bei deren Herstellung die Zeitabhängigkeiten der Impedanz nach Fig. 1B oder 1C gemessen wurden, als nicht gut zu bewerten sind.

Die Impedanzkurve nach Fig. 9 ist das Ergebnis einer korrekt geregelten Prozessführung.

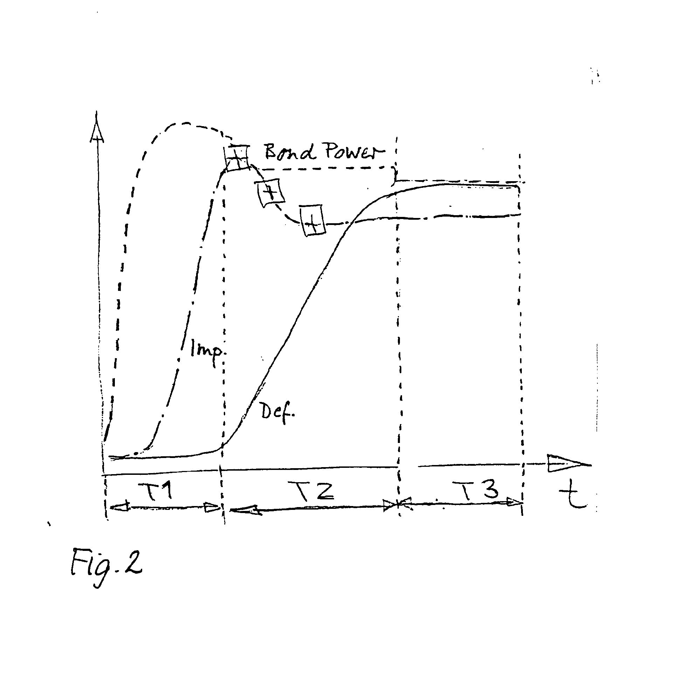

In Fig. 2 sind typische Zeitabhängigkeiten der Impedanz des Transducers und der Deformation des Bonddrahtes in synoptischer Weise zusammen mit einer (gesteuerten) Zeitabhängigkeit der Bondenergie dargestellt. Die Zeitspanne T1 bis zum Einsetzen eines starken Anstieges der Deformations-Zeit-Kurve und annähernd zum Maximum der Impedanz-Zeit-Kurve ist eine Zeitspanne, in der durch die mittels des Transducers erzeugte Schwingung des Bonddrahtes auf der Substratoberfläche eine Reinigung derselben stattfindet. In der Zeitspanne T2 findet eine stoffliche Vermischung zwischen Bonddraht und Substratmaterial, also die eigentliche Verschweißung, statt, und der Reinigunggsprozess setzt sich fort. In der Zeitspanne T3 findet ein Tempern der Schweißverbindung unter der Wirkung der erzeugten Wärme statt.

Sinnvoll ist eine dreistufige Steuerung der Bondenergie, wobei eine erste stufenartige Verringerung in Abhängigkeit von der Erfassung der Zeitabhängigkeit der Impedanz zum Zeitpunkt T1 und eine zweite stufenartige Verringerung in Abhängigkeit von der Auswertung der Zeitabhängigkeit der Deformation zum Zeitpunkt T2 erfolgt. Zum Zeitpunkt T3 kann der Bondvorgang beendet werden.

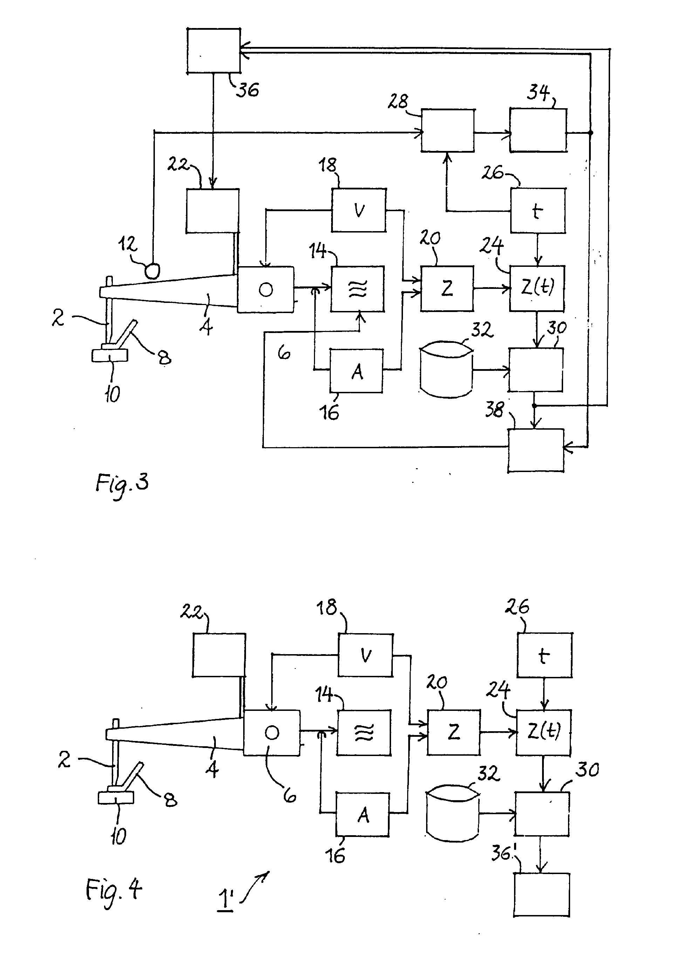

In Fig. 3 ist schematisch eine Anordnung 1 zur Durchführung eines in Abhängigkeit von der Impedanz-Zeit-Kurve gesteuerten Bondprozesses dargestellt, die in einen (nicht insgesamt dargestellten) Drahtbonder integriert sein kann. Von den üblichen Komponenten eines Drahtbonders ist ein Bondwerkzeug 2, der am Horn 4 eines Ultraschallwandlers 6 angebracht ist und zum Herstellen einer Bondverbindung mittels eines Bonddrahtes 8 auf einem Substrat 10 dient, dargestellt.

Dem Horn 4 des Ultraschallwandlers (Transducers) 6 ist ein - an sich bekannter - Deformationssensor 12 zugeordnet. In eine . Stromversorgung 14 des Transducers 6 sind eine Stromstärke-Meßeinrichtung 16 und eine Spannungsmeßeinrichtung 18 integriert, welche ausgangsseitig mit einer Impedanzbestimmungsein-richtung 20 zur Berechnung momentaner Impedanzwerte verbunden sind. Dem Transducer 6 ist ein Bondkopfantrieb 22 zugeordnet, der eine vorbestimmte Andruckkraft (Bondkraft) erzeugt, die das Bondwerkzeug 2 auf den Bonddraht 8 ausübt. Mit dem Ausgang der Impedanzbestimmungseinrichtung 20 ist eine Impedanz-Registriereinrichtung 24 zur Registrierung der Zeitabhängigkeit der Impedanz verbunden, welche über einen weiteren Eingang mit einem Zeitgeber 26 verbunden ist. Der Deformationssensor 12 ist mit dem Eingang einer Deformations-Registriereinrichtung 28 zur Registrierung der Zeitabhängigkeit der Bonddrahtdeformation verbunden, welche ebenfalls ein Zeitsignal von dem Zeitgeber 26 erhält.

Die Impedanz-Registriereinrichtung 24 ist ausgangsseitig mit einer Impedanz-Auswertungseinrichtung 30 verbunden, welche über einen weiteren Eingang mit einer Referenz-Datenbasis 32 verbunden ist. Der Ausgang der Deformations-Registriereinrichtung 28 ist mit einer Deformations-Auswertungseinrichtung 34 verbunden. Beide Auswertungseinrichtungen 30 und 34 sind gemeinsam einerseits mit einer Bondkraft-Steuereinheit 36 und andererseits mit einer Bondenergie-Steuereinheit 38 verbunden. Die Bondkraft-Steuereinheit 36 wirkt auf den Bondkopfantrieb 22 zur schnellen Steuerung der Bondkraft ein, und die Bondenergie-Steuereinheit 38 wirkt auf die Stromversorgung 14 des Transducers 6 zur schnellen Steuerung der Bondenergie (Ultraschall-Schwingungsenergie) ein.

Die Funktionsweise der Meß- und Steueranordnung 1 ergibt sich bereits aus den obigen allgemeinen Ausführungen zum vorgeschlagenen Verfahren und wird daher insoweit hier nicht nochmals beschrieben. Es wird darauf hingewiesen, dass in den Auswertungseinrichtungen 30 und 34 und den Steuereinheiten 36 und 38 Auswertungs- bzw. Steueralgorithmen gespeichert sind, die aus experimentell an einer Mehrzahl von Substraten mit verschiedenen Bonddrähten und Verfahrensparameter-Konstellationen gewonnenen Messkurven der Transducerimpedanz und Drahtbondfeformation und zugehörigen üblichen Qualitätsuntersuchungen abgeleitet sind. Derartige Messungen und Qualitätsprüfungen sind dem Fachmann der Bondtechnik geläufig, so dass er konkrete Steueralgorithmen für konkrete Bauelemente, Substrate und Bonddrähte selbst finden kann.

Fig. 4 zeigt eine gegenüber der Meß- und Steueranordnung 1 nach Fig. 3 wesentlich vereinfachte Testanordnung 1'. Hierbei hat ein Drahtbonder mit dem üblichen Aufbau - von dem in der Figur wiederum das Bondwerkzeug 2, das Horn 4, der Transducer 6 und der Bondkopfantrieb 22 gezeigt sind - zusätzlich nur die Stromstärke-Meßeinrichtung 16, Spannungmeßeinrichtung 18 und Impedanzbestimmungseinrichtung 20 sowie Impedanz-Registriereinrichtung 24 und Impedanz-Auswertungseinrichtung 30 mit zugehöriger Datenbasis 32. Nicht aber vorhanden sind die in Fig. 3 dargestellten Mittel zur Deformationserfassung und -auswertung und zur Steuerung des Bondprozesses. Statt dessen ist die Impedanzauswertungseinrichtung 30 hier ausgangsseitig mit einer Entscheidungsstufe 36' zur Ausgabe eines Gut- bzw. Schlecht-Signals zur Kennzeichnung der Qualität der Bondverbindung verbunden.

Auch die Funktion dieser erfindungsgemäßen Testanordnung ergibt sich aus den obigen Erläuterungen zum vorgeschlagenen Verfahren.

Der Ausführung der Erfindung ist nicht auf die hier skizzierten Beispiele beschränkt, sondern ebenso in einer Vielzahl von Abwandlungen möglich, die im Rahmen fachgemäßen Handelns liegen. Insbesondere schließt die Erfindung auch eine Bondprozesssteuerung sowie hierfür geeignete Anordnung ein, bei der entweder nur eine Steuerung der Bondkraft oder nur der Bondenergie aufgrund einer kombinierten Auswertung der Transducerimpedanz und Bonddrahtdeformation vorgesehen ist. Auch ein Testverfahren und eine Testanordnung, bei der diese beiden Meßgrößen erfasst und einer kombinierten Auswertung zur Ableitung der Gut-/Schlecht-Entscheidung unterzogen werden, liegt im Rahmen der Erfindung. Außerdem gehört zur Erfindung auch eine Ausführung, bei der sowohl die Bondkraft als auch die Bondenergie allein aufgrund einer Erfassung und Auswertung der Transducerimpedanz gesteuert werden.

### Bezugszeichenliste

- 1: Meß- und Steueranordnung
- 1': Testanordnung
- 2: Bondwerkzeug
- 4: Horn
- 6: Ultraschallwandler (Transducer)
- 8: Bonddraht
- 10: Substrat
- 12: Deformationssensor
- 14: Stromversorgung
- 16: Stromstärke-Meßeinrichtung
- 18: Spannungsmeßeinrichtung
- 20: Impedanzbestimmungseinrichtung
- 22: Bondkopfantrieb
- 24: Impedanz-Registriereinrichtung
- 26: Zeitgeber
- 28: Deformations-Registriereinrichtung
- 30: Impedanz-Auswertungseinrichtung
- 32: Referenz-Datenbasis
- 34: Deformations-Auswertungseinrichgung
- 36: Bondkraft-Steuereinheit
- 36': Entscheidungsstufe
- 38: Bondenergie-Steuereinheit

## Patentansprüche

1. Verfahren zur Herstellung einer Drahtbondverbindung zwischen einem elektronischen Bauelement oder einer Baugruppe und einem Träger unter Energieeintrag in einen Bonddraht durch einen Ultraschallwandler,
**dadurch gekennzeichnet, dass**
während des Energieeintrages die Impedanz des Ultraschallwandlers in Abhängigkeit von der Zeit gemessen,
die Kurvenform der Zeitanhängigkeit einer Auswertung anhand vorbestimmter Vergleichskriterien unterzogen und
die in den Ultraschallwandler eingespeiste Energie und/oder eine auf den Bonddraht ausgeübte Bondkraft in Abhängigkeit von dem Auswertungsergebnis gesteuert wird.

2. Verfahren zur Qualitätskontrolle einer Drahtbondverbindung zwischen einem elektronischen Bauelement oder einer Baugruppe und einem Träger, die unter Energieeintrag in einen Bonddraht durch einen Ultraschallwandler hergestellt ist,
**dadurch gekennzeichnet, dass**
während des Energieeintrages die Impedanz des Ultraschallwandlers in Abhängigkeit von der Zeit gemessen,
die Kurvenform der Zeitanhängigkeit einer Auswertung anhand vorbestimmter Vergleichskriterien unterzogen und
aus dem Auswertungsergebnis selbsttätig eine Entscheidung
über die Güte der Drahtbondverbindung abgeleitet wird.

3. Verfahren nach Anspruch 1 oder 2,
**dadurch gekennzeichnet, dass**
die Auswertung der Kurvenform die Feststellung eines Maximums und eines in einem vorbestimmten Wertebereich liegendenden Abfallsgradienten in einem sich an das Maximum anschließenden Kurvenabschnitt der Zeitabhängigkeit der Impedanz umfasst.

4. Verfahren nach einem der vorangehenden Ansprüche,
**dadurch gekennzeichnet, dass**
die Auswertung der Kurvenform die Feststellung umfasst, ob die Kurve der Zeitabhängigkeit der Impedanz drei vorbestimmte Referenzfenster passiert.

5. Verfahren nach einem der vorangehenden Ansprüche,
**dadurch gekennzeichnet, dass**
die Auswertung der Kurvenform den mindestens abschnittsweisen Vergleich mit mindestens einer Referenzkurve, insbesondere einer Schar von Referenzkurven, umfasst.

6. Verfahren nach einem der Ansprüche 2 bis 3,
**dadurch gekennzeichnet, dass**
die Entscheidung zur Güte der Drahtbondverbindung positiv ist, wenn ein Maximum auftritt und der Abfallsgradient innerhalb des Wertebereiches liegt.

7. Verfahren nach Anspruch 2 und 4,
**dadurch gekennzeichnet, dass**
die Entscheidung zur Güte der Drahtbondverbindung positiv ist, wenn die Kurve alle vorbestimmten Fenster durchläuft.

8. Verfahren nach einem der vorangehenden Ansprüche,
**dadurch gekennzeichnet, dass**
neben der Impedanz eine Deformation des Bonddrahtes während des Energieeintrages in Abhängigkeit von der Zeit gemessen und die in den Ultraschallwandler eingespeiste Energie bzw. Bondkraft in Abhängigkeit auch von der Kurve der Zeitabhängigkeit der Deformation gesteuert wird.

9. Verfahren nach Anspruch 8,
**dadurch gekennzeichnet, dass**
die eingespeiste Energie und/oder die Bondkraft zum Zeitpunkt der Feststellung eines starken Anstieges der Deformation des Bonddrahtes, insbesondere stufenartig, verringert wird.

10. Verfahren nach einem der vorangehenden Ansprüche,
**dadurch gekennzeichnet, dass**
die Steuerung der eingespeisten Energie und/oder Bondkraft mindestens eine Regelungskomponente aufweist.

11. Anordnung (1; 1') zur Durchführung des Verfahrens nach einem der vorangehenden Ansprüche, **gekennzeichnet durch**
- eine dem Ultraschallwandler (4; 6) zugeordnete Impedanz messeinrichtung (16,; 18; 20),
- eine signalmäßig mit einem Ausgang der Impedanzmesseinrichtung sowie steuerungsmäßig mit einer Zeitsteuereinrichtung (26) oder einer Bondprozess-Steuereinrichtung verbundene Registriereinrichtung (24) zur Regisrie rung der Zeitabhängigkeit des Ausgangssignals der Impedanzmesseinrichtung in einem vorbestimmten Zeitbereich des Bondprozesses,
- eine Auswertungseinrichtung (30) zur Auswertung der Kurve der Zeitabhängigkeit und
- eine mit einem Ausgang der Auswertungseinrichtung verbundenen Bondkraft-Steuereinheit (36) und/oder Bondener gie Steuereinheit (38) oder
- eine mit dem Ausgang der Auswertungseinrichtung verbun dene Entscheidungsstufe (36') zur Ausgabe eines die Güte der Drahtbondverbindung kennzeichnenden Entscheidungssignals.

12. Anordnung nach Anspruch 11,
**dadurch gekennzeichnet, dass**
die Auswertungseinrichtung (30) einen Referenzspeicher (32) zur Speicherung der Referenzfenster oder mindestens einer Referenzkurve und eine Vergleichereinheit zum Vergleich der aufgenommenen Kurve der Zeitabhängigkeit mit der Referenzkurve oder den Referenzkurven oder zur Prüfung ihres Durchganges durch die vorbestimmten Fenster aufweist.

13. Anordnung nach Anspruch 11 oder 12,
**dadurch gekennzeichnet, dass**
mindestens eine der Steuereinrichtungen (36; 38) zur Steuerung der Bondenergie bzw. der Bondkraft ein Rückkopplungsglied zur Realisierung einer Regelungskomponente aufweist.

14. Drahtbonder mit einer Anordnung nach einem der Ansprüche 10 bis 13.
